# EUROPEAN PATENT APPLICATION

(11) **EP 3 843 504 A1**
(43) Date of publication of application: **30.06.2021**
(21) Application number: 19851659.3
(22) Date of filing: 09.08.2019
(51) Int. Cl.: H05B 33/10, H01L 51/50

(54) **METHOD FOR MANUFACTURING ELECTRONIC DEVICE**

(30) Priority: 21.08.2018 JP 2018154661
(71) Applicant: SUMITOMO CHEMICAL COMPANY LIMITED, Chuo-ku Tokyo 104-8260 (JP)
(72) Inventor: NODA Motoo, Niihama-shi, Ehime 792-0015 (JP); OCHIAI Koshiro, Niihama-shi, Ehime 792-0015 (JP); TERANISHI Norihisa, Fukui-shi, Fukui 918-8560 (JP); SAWAZAKI Hiroshi, Fukui-shi, Fukui 918-8560 (JP)
(74) Representative: J A Kemp LLP
(86) International application number: PCT/JP2019/031768
(87) International publication number: WO 2020/039991

(57) **Abstract**

A method for manufacturing an electronic device according to one embodiment includes forming a first electrode layer, forming a device functional portion, and forming a second electrode layer. At least one of the first electrode layer, one or a plurality of functional layers of the device functional portion, and the second electrode layer is formed by coating a base substrate containing a substrate with ink containing a material of the at least one layer from an inkjet printing device 24. The inkjet printing device includes an ink supply unit 30, an inkjet head 28, a flow path 38 of the ink, a drive unit 40, and a diaphragm type pressure adjusting mechanism 42 which is arranged between the drive unit and the inkjet head on the flow path. The ink satisfies at least one of a surface tension of 15 mN/m to 25 mN/m and a specific gravity of 1.5 or more.

## Description

### TECHNICAL FIELD

The present invention relates to a method for manufacturing an electronic device.

### BACKGROUND ART

The electronic device includes a first electrode layer provided on a substrate, a device functional portion provided on the first electrode layer and including one or a plurality of functional layers, and a second electrode layer provided on the device functional portion. When this electronic device is manufactured, at least one of the first electrode layer, the one or more functional layers, and the second electrode layer is formed using an inkjet printing method as described in Patent Document 1.

### PRIOR ART DOCUMENTS

### PATENT DOCUMENTS

Patent Document 1: JP-A-2013-141765

### SUMMARY OF THE INVENTION

### PROBLEMS TO BE SOLVED BY THE INVENTION

When a layer of an electronic device is formed by using an inkjet printing method, the ink is sent from an ink supply unit to an inkjet head, and the ink is ejected from the inkjet head. A drive unit (for example, a pump) for flowing ink from the ink supply unit to the inkjet head is arranged between the ink supply unit and the inkjet head. However, when the ink is pressed by the drive unit to allow the ink to flow, the pressure of the ink pulsates, and the shape of the meniscus of the ink ejected from the inkjet head becomes unstable. Therefore, in the flow path of the ink, it is conceivable to dispose a pressure adjusting mechanism having a function of suppressing the pulsation of the ink between the drive unit and the inkjet head. The upstream ink tank in Patent Document 1 corresponds to the pressure adjusting mechanism. In Patent Document 1, the pressure adjusting mechanism utilizing an air reservoir, that is, an air damper is adopted.

However, even if the pressure adjusting mechanism is adopted as described above, the shape of the ink meniscus becomes unstable with time, and as a result, the layer in a desired state may not be formed. The layer state of an electronic device affects the performance of the electronic device. Therefore, if the ink is ejected in the shape of an unstable meniscus as described above and a layer in a desired state cannot be formed, the manufactured electronic device is determined to be a defective product that does not have the desired performance. Therefore, the manufacturing yield of the electronic device is lowered.

One aspect of the invention is to provide a method for manufacturing an electronic device capable of improving a manufacturing yield.

### MEANS FOR SOLVING THE PROBLEMS

A method for manufacturing an electronic device according to one aspect of the invention includes forming a first electrode layer on a substrate, forming a device functional portion including one or a plurality of functional layers on the first electrode layer, and forming a second electrode layer on the device functional portion. At least one of the first electrode layer, the one or more functional layers, and the second electrode layer is formed by coating a base substrate containing the substrate with ink containing a material of the at least one layer from an inkjet printing device. The inkjet printing device includes an ink supply unit, an inkjet head that includes an ink ejection port for ejecting the ink toward the base substrate, a flow path of the ink which connects the ink supply unit and the inkjet head, a drive unit that is arranged between the ink supply unit and the inkjet head on the flow path to cause the ink to flow to the flow path, and a diaphragm type pressure adjusting mechanism that is arranged between the drive unit and the inkjet head on the flow path. The ink satisfies at least one of a surface tension of 15 mN/m to 25 mN/m and a specific gravity of 1.5 or more.

The method for manufacturing the electronic device includes forming a layer (hereinafter, referred to as "predetermined layer" for convenience of explanation) by an inkjet printing method using ink satisfying a surface tension of 15 mN/m to 25 mN/m and a specific gravity of 1.5 or more. In the inkjet printing device used in the forming of the predetermined layer, a diaphragm type pressure adjusting mechanism is arranged between the drive unit and the inkjet head on the flow path of the ink. In this case, since the pulsation of the ink pressure generated by the drive unit is suppressed by the pressure adjusting mechanism, it is easy to maintain the shape of the meniscus of the ink ejected from the inkjet head. As a result, the predetermined layer can be formed in a desired state, so that an electronic device having a desired performance can be efficiently manufactured. Therefore, in the above-mentioned manufacturing method of the electronic device, the manufacturing yield is improved.

The ink may be circulated between the ink supply unit and the inkjet head.

The ink may be circulated continuously between the ink supply unit and the inkjet head for one week or longer. In this case, the method for manufacturing the electronic device is more effective.

The ink may be periodically purged from the inkjet head. As a result, it is easy to maintain the shape of the ink meniscus, and it is easy to prevent clogging of the ink ejection port of the inkjet head.

The ink may contain a solvent having a boiling point of 200°C or higher and a substance having a 1% or less solubility to the solvent.

The at least one layer may be a layer included in the device functional portion.

The device functional portion may include an organic light emitting layer. In this case, an organic electroluminescence device can be manufactured as an electronic device.

### EFFECT OF THE INVENTION

According to one aspect of the invention, it is possible to provide a method for manufacturing an electronic device capable of improving the manufacturing yield.

### BRIEF DESCRIPTION OF THE DRAWINGS

Fig. 1 is a schematic diagram illustrating a schematic configuration of an organic EL device (electronic device) manufactured by using the method for manufacturing the electronic device according to an embodiment.
Fig. 2 is a schematic diagram for explaining an example of an inkjet printing device used in the method for manufacturing the electronic device according to an embodiment.
Fig. 3 is a schematic diagram for explaining a process of forming a layer by using the inkjet printing device illustrated in Fig. 2.

### MODE FOR CARRYING OUT THE INVENTION

Hereinafter, embodiments of the invention will be described with reference to the drawings. The same elements are designated by the same reference numerals, and duplicate description will be omitted. The dimensional ratios in the drawings do not always match those described.

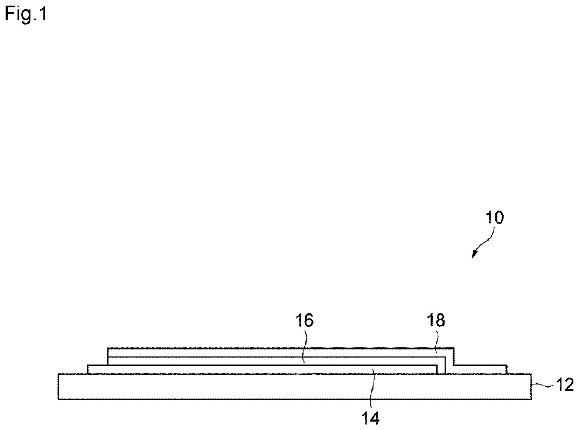

Fig. 1 is a schematic diagram illustrating a schematic configuration of an organic electroluminescence device (hereinafter, also referred to as "organic EL device") manufactured by using the method for manufacturing the electronic device according to an embodiment. The organic EL device 10 includes a substrate 12, an anode layer (first electrode layer) 14, a device functional portion 16, and a cathode layer (second electrode layer) 18. The anode layer 14, the device functional portion 16, and the cathode layer 18 are laminated on the substrate 12 in the order of the anode layer 14, the device functional portion 16, and the cathode layer 18. The organic EL device 10 may be a top emission type organic EL device or a bottom emission type organic EL device. In the following, unless otherwise specified, the organic EL device 10 is a bottom emission type organic EL device.

### [Substrate]

The substrate 12 has translucency with respect to the light emitted by the organic EL device 10 (including visible light having a wavelength of 400 nm to 800 nm). An example of the thickness of the substrate 12 is 30 µm to 1100 µm.

The substrate 12 may be, for example, a rigid substrate such as a glass substrate and a silicon substrate, or a flexible substrate such as a plastic substrate and a polymer film. The flexible substrate is a substrate having a property that the substrate can be bent without being sheared or broken even when a predetermined force is applied to the substrate.

When the substrate 12 is a rigid substrate, an example of the thickness of the substrate 12 is 50 µm to 1100 µm. When the substrate 12 is a flexible substrate, an example of the thickness of the substrate 12 is 30 µm to 700 µm.

A barrier layer having a moisture barrier function may be formed on the substrate 12. The barrier layer may have a function of barriering gas (for example, oxygen) in addition to a function of barriering water.

### [Anode layer]

The anode layer 14 is provided on the substrate 12. An electrode exhibiting light transmission is used for the anode layer 14. An example of an electrode exhibiting light transmission is a thin film containing a metal oxide, a metal sulfide, a metal, or the like having high electrical conductivity. The electrode exhibiting light transmission is preferably a thin film having high light transmittance. The anode layer 14 may have a network structure formed of a conductor (for example, metal). The thickness of the anode layer 14 can be determined in consideration of light transmission, electrical conductivity, and the like. The thickness of the anode layer 14 is usually 10 nm to 10 µm, preferably 20 nm to 1 µm, and more preferably 50 nm to 500 nm.

Examples of the material of the anode layer 14 include indium oxide, zinc oxide, tin oxide, indium tin oxide (abbreviated as ITO), indium zinc oxide (abbreviated as IZO), gold, platinum, silver, and copper. Among them, ITO, IZO, or tin oxide is preferable. The anode layer 14 can be formed, for example, as a thin film containing the exemplified materials. As the material of the anode layer 14, organic substances such as polyaniline and its derivative, polythiophene and its derivative may be used. In this case, the anode layer 14 can be formed as a transparent conductive film.

### [Device functional portion]

The device functional portion 16 is a functional unit that contributes to light emission of the organic EL device 10 such as charge transfer and charge recombination according to the voltage applied to the anode layer 14 and the cathode layer 18. The device functional portion 16 has a light emitting layer which is a functional layer. The device functional portion 16 may have a functional layer other than the light emitting layer. That is, the device functional portion 16 has one or a plurality of functional layers.

The light emitting layer is an organic light emitting layer having a function of emitting light (including visible light). The light emitting layer is usually formed mainly of an organic substance that emits at least one of fluorescence and phosphorescence, or a dopant material that assists the organic substance. Dopant materials are added, for example, to improve luminous efficiency and change the emission wavelength. The organic substance may be a low molecular weight compound or a high molecular weight compound. An example of the thickness of the light emitting layer is 2 nm to 200 nm.

Examples of organic substances that are luminescent materials that mainly emit at least one of fluorescence and phosphorescence include the following pigment-based materials, metal complex-based materials, and polymer-based materials.

### (Pigment-based material)

Examples of the pigment-based material include cyclopendamine derivatives, tetraphenylbutadiene derivative compounds, triphenylamine derivatives, oxaziazole derivatives, pyrazoloquinolin derivatives, distyrylbenzene derivatives, distyrylarylene derivatives, pyrrole derivatives, thiophene ring compounds, pylin ring compounds, perinone derivatives, perylene derivatives, oligothiophene derivatives, oxaziazole dimers, pyrazoline dimers, quinacridone derivatives, coumarin derivatives, and the like.

### (Metal complex-based material)

Examples of the metal complex-based material include a metal complex that has rare earth metals such as Tb, Eu, and Dy, or Al, Zn, Be, Ir, and Pt as the central metal, and contains oxadiazole, thiadiazole, phenylpyridine, phenylbenzimidazole, and quinoline as a ligand. Examples of metal complex-based material include an iridium complex, a metal complex that emits light from a triple-term excited state such as a platinum complex, an aluminum quinolinol complex, a benzoquinolinol berylium complex, a benzoxazolyl zinc complex, a benzothiazole zinc complex, and an azomethylzinc complex, a porphyrin zinc complex, a phenanthroline europium complex, and the like.

### (Polymer-based material)

As the polymer-based material, polyparaphenylene vinylene derivatives, polythiophene derivatives, polyparaphenylene derivatives, polysilane derivatives, polyacetylene derivatives, polyfluorene derivatives, polyvinylcarbazole derivatives, derivatives obtained by polymerizing the above-mentioned pigment-based material or a metal complex-based luminescent material, and the like.

### (Dopant material)

Examples of the dopant material include perylene derivatives, coumarin derivatives, rubrene derivatives, quinacridone derivatives, squalium derivatives, porphyrin derivatives, styryl dye, tetracene derivatives, pyrazolone derivatives, decacyclene, phenoxazones, and the like.

The device functional portion 16 may have at least one functional layer in addition to the light emitting layer. That is, the device functional portion 16 may have a multi-layer configuration. For example, at least one of a hole injection layer and a hole transport layer may be provided between the anode layer 14 and the light emitting layer. At least one of an electron transport layer and an electron injection layer may be provided between the light emitting layer and the cathode layer 18.

The hole injection layer is a functional layer having a function of improving the hole injection efficiency from the anode layer 14 to the light emitting layer. The hole injection layer may be an inorganic layer or an organic layer. The hole injection material constituting the hole injection layer may be a low molecular weight compound or a high molecular weight compound.

Examples of the low molecular weight compound include metal oxides such as vanadium oxide, molybdenum oxide, ruthenium oxide, and aluminum oxide, metal phthalocyanine compounds such as copper phthalocyanine, and carbon.

Examples of the high molecular weight compound include polyaniline, polythiophene, polythiophene derivatives such as polyethylene dioxythiophene (PEDOT), polypyrrole, polyphenylene vinylene, polythienylene vinylene, polyquinoline and polyquinoxaline, and derivatives thereof; and conductive polymers such as polymers containing aromatic amine structures in the main chain or the side chain.

The optimal value for the thickness of the hole injection layer differs depending on the material used. The thickness of the hole injection layer may be appropriately determined in consideration of the required characteristics, the ease of film formation, and the like. The thickness of the hole injection layer is, for example, 1 nm to 1 µm, preferably 2 nm to 500 nm, and more preferably 5 nm to 200 nm.

The hole transport layer is a functional layer having a function of improving the hole injection efficiency from the hole injection layer (the anode layer 14 in the form where the hole injection layer does not exist) to the light emitting layer.

The hole transport layer is an organic layer containing a hole transport material. The hole transport material is not limited as long as it is an organic compound having a hole transport function. Examples of the organic compound having a hole transport function include polyvinylcarbazole or its derivative, polysilane or its derivative, polysiloxane derivatives having an aromatic amine residue in the side chain or the main chain, pyrazoline derivatives, arylamine derivatives, stillben derivatives, triphenyldiamine derivatives, polyaniline or its derivative, polythiophene or its derivative, polypyrrole or its derivative, polyarylamine or its derivative, poly (p-phenylene vinylene) or its derivative, polyfluorene derivatives, high molecular weight compounds having an aromatic amine residue, and poly (2,5-thienylene vinylene) or its derivative.

Examples of hole transport material include hole transport materials described in JP-A-63-70257, JP-A-63-175860, JP-A-2-135359, JP-A-2-135361, JP-A-2-209988, JP-A-3-37992, and JP-A-3-152184.

The optimal value for the thickness of the hole transport layer differs depending on the material used. The thickness of the hole transport layer may be appropriately determined in consideration of the required characteristics, the ease of film formation, and the like. The thickness of the hole transport layer is, for example, 1 nm to 1 µm, preferably 2 nm to 500 nm, and more preferably 5 nm to 200 nm.

The electron transport layer is a functional layer having a function of improving the electron injection efficiency from the electron injection layer (the cathode layer 18 in the form where the electron injection layer does not exist) to the light emitting layer.

The electron transport layer is an organic layer containing an electron transport material. A known material can be used as the electron transport material. An example of an electron transport material is a material in which an aromatic hydrocarbon compound is doped with an alkali metal salt or an alkaline earth metal salt. Specific examples of the electron transport material include oxadiazole derivatives, anthraquinodimethane or its derivative, benzoquinone or its derivative, naphthoquinone or its derivative, anthraquinone or its derivative, tetracyanoanthraquinodimethane or its derivative, fluorenone derivatives, diphenyldicyanoethylene or its derivative, diphenoquinone derivative, or a metal complex of 8-hydroxyquinoline or its derivative, polyquinolin or a derivative thereof, polyquinoxaline or its derivative, polyfluorene or its derivative, and the like.

The thickness of the electron transport layer can be appropriately determined in consideration of the required characteristics, the ease of film formation, and the like. The thickness of the electron transport layer is, for example, 1 nm to 1 µm, preferably 2 nm to 500 nm, and more preferably 5 nm to 200 nm.

The electron injection layer is a functional layer having a function of improving the electron injection efficiency from the cathode layer 18 to the light emitting layer.

The electron injection layer may be an inorganic layer or an organic layer. As the material of the electron injection layer, the optimum material is appropriately selected according to the type of the light emitting layer. Examples of materials for the electron injection layer are alkali metals, alkaline earth metals, alloys containing one or more of alkali metals and alkaline earth metals, alkali metal or alkali earth metal oxides, halides, carbonates, or mixtures of these substances. Examples of alkali metals, alkali metal oxides, halides, and carbonates include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, lithium carbonate, and the like. Examples of alkaline earth metals, oxides, halides, and carbonates of alkaline earth metals are magnesium, calcium, barium, strontium, magnesium oxide, magnesium fluoride, calcium oxide, calcium fluoride, barium oxide, barium fluoride, strontium oxide, strontium fluoride, magnesium carbonate, and the like.

In addition to these, a layer obtained by mixing a conventionally known electron-transport organic material and an organometallic complex of an alkali metal can be used as an electron injection layer.

An example of the layer configuration of the device functional portion 16 is illustrated below. In the example of the layer configuration below, the anode layer and the cathode layer are also illustrated in parentheses in order to illustrate the arrangement relationship between the anode layer 14 and the cathode layer 18 and various functional layers.
(a) (Anode layer)/Hole injection layer/Light emitting layer/(Cathode layer)
(b) (Anode layer)/Hole injection layer/Light emitting layer/Electron injection layer/(Cathode layer)
(c) (Anode layer)/Hole injection layer (or hole transport layer)/Light emitting layer/Electron transport layer/Electron injection layer/(Cathode layer)
(d) (Anode layer)/Hole injection layer/Hole transport layer/Light emitting layer/(Cathode layer)
(e) (Anode layer)/Hole injection layer/Hole transport layer/Light emitting layer/Electron injection layer/(Cathode layer)
(f) (Anode layer)/Hole injection layer/Hole transport layer/Light emitting layer/Electron transport layer/Electron injection layer/(Cathode layer)
(g) (Anode layer)/Light emitting layer/Electron transport layer (or electron injection layer)/(Cathode layer)
(i) (Anode layer)/Light emitting layer/Electron transport layer/Electron injection layer/(Cathode layer)

The symbol "/" means that the layers on both sides of the symbol "/" are joined together.

The number of light emitting layers included in the device functional portion 16 may be one or two or more. In any one of the layer configurations of the above configuration examples (a) to (i), if the laminate arranged between the anode layer 14 and the cathode layer 18 is referred to as [Structure unit I], the layer configuration illustrated in (j) below can be exemplified as the configuration of the device functional portion 16 having two light emitting layers. The layer configuration of the two structure units I may be the same or different from each other.
(j) (Anode layer)/[Structure unit I]/Charge generation layer/[Structure unit I]/(Cathode layer)

The charge generation layer is a layer that generates holes and electrons by applying an electric field. Examples of the charge generation layer include a thin film containing vanadium oxide, ITO, molybdenum oxide, and the like.

When the "[Structure unit I]/Charge generation layer" is referred to as [Structure unit II], the configuration of the organic EL device having three or more light emitting layers includes the layer configuration illustrated in (k) below.
(k) (Anode layer)/[Structure unit II]x/[Structure unit I]/(Cathode layer)

The symbol "x" represents an integer of 2 or more, and "[Structure unit II]x" represents a laminated body in which [Structure unit II] is laminated in x stages. The layer configuration of the plurality of structure units II may be the same or different.

The device functional portion 16 may be configured by directly laminating a plurality of light emitting layers without providing the charge generation layer.

### [Cathode layer]

The cathode layer 18 is provided on the device functional portion 16. The optimal value of the thickness of the cathode layer 18 differs depending on the material used, and is set in consideration of electrical conductivity, durability, and the like. The thickness of the cathode layer 18 is usually 10 nm to 10 µm, preferably 20 nm to 1 µm, and more preferably 50 nm to 500 nm.

As the material of the cathode layer 18, a material having a high reflectance with respect to the light (particularly, visible light) from the light emitting layer of the device functional portion 16 is preferable so that the light (specifically, the light from the light emitting layer) from the device functional portion 16 is reflected on the cathode layer 18 and proceeds toward the anode layer 14. Examples of the material of the cathode layer 18 include aluminum and silver. As the cathode layer 18, a transparent conductive electrode containing a conductive metal oxide, a conductive organic substance, or the like may be used.

The organic EL device 10 may include a sealing member for preventing deterioration of the device functional portion 16 due to moisture or the like. The sealing member may be provided on the cathode layer 18 so as to seal at least the device functional portion 16. In the form in which the organic EL device 10 includes a sealing member, for example, a part of the anode layer 14 and the cathode layer 18 can be pulled out from the sealing member for external connection.

Next, an example of a method for manufacturing the organic EL device 10 will be described. When the organic EL device 10 is manufactured, the anode layer (first electrode layer) 14 is formed on the substrate 12 (first electrode layer forming process). After that, the device functional portion 16 is formed on the anode layer 14 (device functional portion forming process). Subsequently, the cathode layer (second electrode layer) 18 is formed on the device functional portion 16 (second electrode layer forming process). By going through such a process, the organic EL device 10 is manufactured.

In the form in which the organic EL device 10 includes a sealing member, a sealing process of sealing the device functional portion 16 with the sealing member may be performed after the second electrode layer forming process.

When, for example, the long substrate 12 is used for manufacturing the organic EL device 10, a plurality of device forming regions are virtually set on the long substrate 12, for example. The anode layer 14, a device functional portion 16, and a cathode layer 18 are formed for each set device forming region. As a result, the organic EL device 10 is formed in each device forming region. Therefore, a plurality of organic EL devices 10 can be manufactured by separating the long substrate 12 into individual pieces for each device forming region.

In the form in which the long substrate 12 has flexibility, at least one process of the first electrode layer forming process, the device functional portion forming process, and the second electrode layer forming process may be carried out by, for example, a roll-to-roll method. In the form in which the device functional portion 16 includes a plurality of functional layers, at least one process of each forming the plurality of functional layers may be carried out in a roll-to-roll manner.

Next, the manufacturing method of the organic EL device 10 will be further described.

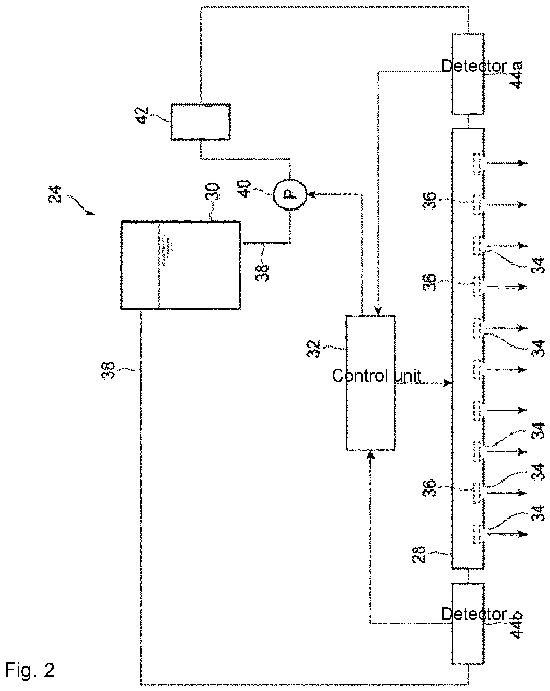

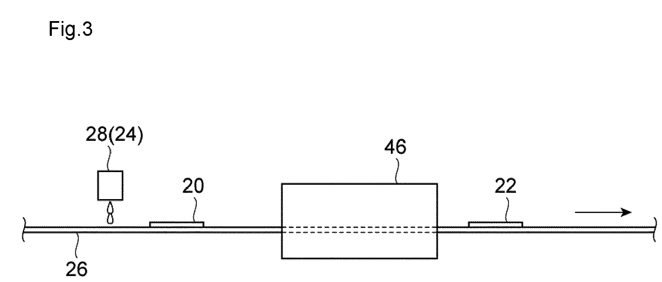

In the method for manufacturing the organic EL device 10, at least one of the anode layer 14, one or more functional layers of the device functional portion 16, and the cathode layer 18 (hereinafter, for convenience of explanation, referred to as "predetermined layer") is formed by an inkjet printing method using an inkjet printing device. Hereinafter, an example of the process of forming the predetermined layer will be specifically described with reference to Figs. 2 and 3.

Fig. 2 is a schematic diagram for explaining a schematic configuration of an inkjet printing device for forming a predetermined layer. Fig. 3 is a diagram for explaining a process of forming a predetermined layer. For convenience of explanation, the predetermined layer is referred to as a predetermined layer 22, the coating film to be the predetermined layer 22 is referred to as a coating film 20, and the base substrate on which the predetermined layer 22 is formed is referred to as a base substrate 26. The base substrate 26 includes the substrate 12. In a form in which at least one layer is arranged between the substrate 12 and the predetermined layer 22, the base substrate 26 includes the substrate 12 and at least one layer arranged between the substrate 12 and the predetermined layer 22. An example of the predetermined layer 22 is at least one layer (for example, an electron transport layer) included in the device functional portion 16.

As illustrated in Fig. 2, an inkjet printing device 24 includes an inkjet head 28, an ink supply unit 30, a control unit 32, a flow path 38, a pump 40, and a pressure adjusting mechanism 42. The control unit 32 controls the inkjet printing device 24.

The inkjet head 28 extends in one direction. The inkjet head 28 is formed with a plurality of ink ejection ports 34 discretely arranged in the above one direction (the width direction of the base substrate 26). A piezoelectric element 36 (for example, a piezo element) is provided corresponding to each ink ejection port 34. The diameter of the ink ejection port 34 is, for example, 5 µmϕ to 200 µmϕ. By vibrating the piezoelectric element 36, ink is ejected from the ink ejection port 34. The amount of ink ejected from each of the plurality of ink ejection ports 34 (including the case where the ejection amount is 0) is controlled by the control unit 32.

As illustrated in Fig. 3, the inkjet head 28 is arranged to face the surface of the base substrate 26 on the side where the predetermined layer 22 is formed. The inkjet head 28 is arranged so that the extending direction of the inkjet head 28 substantially coincides with the width direction (direction orthogonal to the longitudinal direction) of the base substrate 26.

By controlling the amount of ink ejected from each of the plurality of ink ejection ports 34 (including the case where the ejection amount is 0) of the inkjet heads 28 arranged as described above by the control unit 32, ink can be applied in a predetermined pattern on a region for forming the predetermined layer 22 in the base substrate 26.

The ink supply unit 30 is an ink storage unit or an ink source in which ink to be supplied to the inkjet head 28 is stored. An example of the ink supply unit 30 is a tank. The ink supply unit 30 and the inkjet head 28 are connected by the flow path 38 for circulating ink between them. That is, the inkjet printing device 24 is a recycling-type inkjet printing device. An example of the flow path 38 is a pipe. The pump 40 and the pressure adjusting mechanism 42 are arranged in the flow path 38.

The pump 40 is arranged between the ink supply unit 30 and the inkjet head 28 in the flow path 38. The pump 40 is a drive unit that sends ink from the ink supply unit 30 toward the inkjet head 28 and circulates the ink between the ink supply unit 30 and the inkjet head 28. The pump 40 can be controlled by the control unit 32.

The pressure adjusting mechanism 42 is arranged between the pump 40 and the inkjet head 28 in the flow path 38. The pressure adjusting mechanism 42 has a pulsation suppressing function of suppressing the pulsation of the ink pressure generated by the pump 40. In order to realize the pulsation suppressing function, the pressure adjusting mechanism 42 has a diaphragm. That is, the pressure adjusting mechanism 42 is a diaphragm type pressure adjusting mechanism. An example of a diaphragm type pressure adjusting mechanism 42 is a pulse damper.

In the diaphragm type pressure adjusting mechanism 42, for example, the lower surface of the ink flow path in the pressure adjusting mechanism 42 may be configured by the diaphragm, and the diaphragm may be connected to an attenuator. In such a configuration, the pulsation of the pressure of the ink flowing into the pressure adjusting mechanism 42 can be attenuated by the attenuator via the diaphragm. As long as the pulsation of the ink pressure is attenuated by the attenuator via the diaphragm, a sealing member such as an O-ring may be arranged between the diaphragm and the attenuator.

In the direction of ink flow in the flow path 38, a pressure detector 44a and a pressure detector 44b may be arranged in the front and rear of the inkjet head 28 as illustrated in Fig. 2. The pressure detector 44a detects the pressure of the ink flowing into the inkjet head 28. The pressure detector 44b detects the pressure of the ink flowing out of the inkjet head 28. The detection results of the pressure detector 44a and the pressure detector 44b are input to the control unit 32. The control unit 32 may control the pump 40 based on the detection results of the pressure detector 44a and the pressure detector 44b so that the pressure of the ink in the inkjet head 28 falls within a predetermined pressure range. As a result, the shape of the ink meniscus at the ink ejection port 34 can be adjusted.

The inkjet printing device 24 may include a plurality of inkjet heads 28. In this case, the plurality of inkjet heads 28 are arranged, for example, along the longitudinal direction of the base substrate 26. In the form in which the inkjet printing device 24 including the plurality of inkjet heads 28 is a circulation type, the ink may circulate between the plurality of inkjet heads 28 and the ink supply unit 30. When the inkjet printing device 24 includes a plurality of inkjet heads 28, the flow path 38 is branched into a plurality of channels downstream of the pressure adjusting mechanism 42 so as to correspond to the plurality of inkjet heads 28, and each branched flow path can be connected to the corresponding inkjet head 28. The plurality of flow paths connected to the plurality of inkjet heads 28 may be connected to the ink supply unit 30 after rejoining downstream of the plurality of inkjet heads 28. When the inkjet printing device 24 includes the plurality of inkjet heads 28 and pressure detectors 44a and 44b, for example, the pressure detectors 44a and 44b may be arranged in a common portion with respect to the plurality of inkjet heads 28 in the flow path 38 in the front and rear of the plurality of inkjet heads 28.

As illustrated in Fig. 3, in the process of forming the predetermined layer 22, the ink containing the material of the predetermined layer 22 is applied from the inkjet printing device 24 to the region for forming the predetermined layer 22 in the base substrate 26 (or the substrate 12) while the base substrate 26 is conveyed in the longitudinal direction thereof so as to form the coating film 20.

The ink containing the material of the predetermined layer 22 is ink that satisfies at least one of the following Conditions 1 and 2.

Condition 1: The surface tension of the ink is 15 mN/m to 25 mN/m.

Condition 2: The specific gravity of the ink is 1.5 or more.

The specific gravity of the ink can usually be 2.5 or less.

An example of the ink for the predetermined layer 22 is ink containing a solvent having a boiling point of 200°C or higher and a substance having a solubility in the solvent of 1% or less (for example, a material for the predetermined layer). With such ink, at least one of the above Conditions 1 and 2 can be easily satisfied.

In the process of forming the predetermined layer 22, after forming the coating film 20, the coating film 20 is dried in a drying device 46. As a result, the predetermined layer 22 is obtained. The drying device 46 may be, for example, a drying device using infrared rays, or a drying device using another method (hot air, hot plate, etc.). The drying device 46 may be a device in which different drying methods are combined.

When the predetermined layer 22 is formed by using the inkjet printing method, the base substrate 26 is preferably conveyed horizontally at least from the time when the ink is applied to the base substrate 26 until the coating film 20 is carried into the drying device 46. For this horizontal transfer, for example, an air levitation device that floats the base substrate 26 to maintain the level may be used.

Of the one or more functional layers and the anode layer 14 of the device functional portion 16, layers other than the predetermined layer 22 can be formed by, for example, a dry film forming method, a plating method, a coating method other than the inkjet printing method, or the like. Examples of the dry film forming method include a vacuum deposition method, a sputtering method, an ion plating method, a CVD method, and the like. Examples of coating methods other than the inkjet printing method include a slit coating method, a micro gravure coating method, a gravure coating method, a bar coating method, a roll coating method, a wire bar coating method, a spray coating method, a screen printing method, a flexo printing method, an offset printing method, a nozzle printing method, and the like.

When the cathode layer 18 is a layer other than the predetermined layer 22, the cathode layer 18 can be formed by, for example, a coating method such as a slit coater method, a gravure printing method, a screen printing method, and a spray coater method, a vacuum deposition method, a sputtering method, a laminating method for thermally depositing a metal thin film, or the like.

In the method for manufacturing the organic EL device 10, when the predetermined layer 22 is not formed, the pump 40 may be controlled while the inkjet printing device 24 is kept on standby (hereinafter, this may be referred to as a "standby process") to circulate ink. The concept of the standby process includes, for example, the case of forming a layer other than the predetermined layer 22 by using the manufacturing method of the organic EL device, the case of making the inkjet printing device 24 stand-by by adjusting the manufacturing conditions, and the like.

The concept of the standby process may include a case that the organic EL device manufacturing method is carried out to manufacture the organic EL device 10 once, and then the inkjet printing device 24 is set on standby until the organic EL device manufacturing method is carried out and the organic EL device 10 is manufactured. In this case, a process of once manufacturing the organic EL device 10 by performing the manufacturing process of the organic EL device 10 including the first electrode layer forming process, the device functional portion forming process, and the second electrode layer forming process is called a first device manufacturing process. Then, a process of manufacturing the organic EL device 10 is called a second device manufacturing process. For example, the manufacturing method of the organic EL device includes the first device manufacturing process, the standby process, and the second device manufacturing process.

The ink circulation in the inkjet printing device 24 may be continuously performed for one week or more. For example, when the period of the standby process is one week or more, the ink circulation may be continued during the standby process. In the manufacturing method of the organic EL device 10, the ink may be purged (that is, ejected) periodically. In the standby process as well, the ink may be purged periodically.

In the manufacturing method for the organic EL device 10 described above, the pulsation of the ink pressure generated by the pump 40 is suppressed using the diaphragm type pressure adjusting mechanism 42 arranged between the pump 40 and the inkjet head 28 in the flow path 38. The diaphragm type pressure adjusting mechanism 42 uses a diaphragm instead of an air reservoir in order to suppress the pulsation of the ink pressure. The ink pressure in the inkjet head 28 is stabilized by suppressing the pulsation of the ink pressure by the diaphragm type pressure adjusting mechanism 42. Therefore, the shape of the ink meniscus is stable, and it is possible to prevent the ink from dripping from the ink ejection port 34.

In addition to the diaphragm type pressure adjusting mechanism, the pressure adjusting mechanism includes a pressure adjusting mechanism using an air reservoir for suppressing pulsation. An example of the pressure adjusting mechanism using the air reservoir is known as an air damper. For example, a buffer tank is also included in the pressure adjusting mechanism using the air reservoir. In the pressure adjusting mechanism using the air pool, the pulsation suppressing function may be deteriorated due to the air constituting the air reservoir being released over time. When the pulsation suppressing function deteriorates due to the release of air over time, the shape of the ink meniscus becomes unstable. As a result, liquid dripping may occur, or the ink may spread and dry on the bottom surface of the inkjet head (the surface facing the base substrate) near the ink ejection port, resulting in clogging of the ink ejection port.

On the other hand, when the diaphragm type pressure adjusting mechanism 42 is used like the pressure adjusting mechanism 42 of this embodiment, the pulsation suppressing function does not deteriorate due to air bleeding, so that the ink pressure is kept stable for a long period of time. Therefore, the shape of the ink meniscus is stable. Further, it is possible to prevent the ink from dripping from the ink ejection port 34.

Next, a verification experiment that verifies that the ink pressure can be stabilized by using the diaphragm type pressure adjusting mechanism 42 and a comparative experiment with the verification experiment will be described. For convenience of explanation, the components corresponding to the components illustrated in Fig. 2 in the verification experiment and the comparative experiment are designated by the same reference numerals as those illustrated in Fig. 2, and duplicate explanations are omitted.

### [Verification experiment]

In the verification experiment, the circulation type inkjet printing device 24 illustrated in Fig. 2 was used. In the inkjet printing device 24 used in the verification experiment, as illustrated in Fig. 2, the pressure adjusting mechanism 42 was arranged between the pump 40 and the inkjet head 28 in the flow path 38. For the pressure adjusting mechanism 42, a pulse damper that suppresses the pulsation of the ink pressure using a diaphragm was used. The pressure detector 44a and the pressure detector 44b were arranged in the front and rear of the inkjet head 28 in the direction of ink flow, and the pressure of the ink flowing into the inkjet head 28 and the pressure of the ink flowing out of the inkjet head 28 were detected.

The ink is ink for an electron transport layer. The surface tension of the ink is 20 mN/m. The specific gravity of the ink is 1.7.

In the verification experiment, the ink pressure calculated based on the ink pressures detected by the pressure detector 44a and the pressure detector 44b and a predetermined calculation formula was used as the ejection port pressure.

In the verification experiment, at the start of the experiment, a water absorbing sheet for transferring the ink ejected below the inkjet printing device 24 was conveyed, the ink was ejected for a certain period of time, the fluctuation state of the ejection port pressure during the ejection of the ink was acquired, and the presence or absence of liquid dripping from the ink ejection port 34 and the ink ejection state were confirmed. The presence or absence of liquid dripping was confirmed based on the presence or absence of ink landing on a place other than the target landing position of the ink on the water absorbing sheet, and the ink ejection state was confirmed based on whether the ink has landed at the target landing position.

After the ink ejection for the above-mentioned certain time, the ink ejection was stopped, and the inkjet printing was allowed to wait for one day while the ink circulation was continued, and then the ink ejection was performed under the same conditions as at the start of the experiment.

The above ink ejection and one-day waiting of the inkjet printing device were repeated for 30 days from the start date of the experiment. In the daily ink ejection, as in the case of the ink ejection at the start of the experiment, the fluctuation state of the ejection port pressure during the ink ejection was acquired, and the presence or absence of liquid dripping from the ink ejection port 34 and the ejection state were confirmed.

In the daily ink ejection performed from the start date of the experiment to 30 days later, the variation in the ejection pressure was ±150 Pa. Further, no liquid dripping was confirmed, and the ink ejection state was also good. The good ejection state means that the ink ejection port 34 is not clogged, that is, the ink is landed at all the target landing positions.

### [Comparative experiment]

Next, a comparative experiment with respect to the above verification experiment will be described. In the comparative experiment, as the pressure adjusting mechanism 42, a buffer tank using an air reservoir was used to suppress the pulsation of the ink pressure instead of the pressure adjusting mechanism 42 (pulse damper) equipped with the diaphragm used in the verification experiment. Except for this point, the comparative experiment was conducted under the same conditions as that of the verification experiment. Therefore, the method of calculating the ejection port pressure, the method of confirming the presence or absence of liquid dripping, and the method of confirming the ink ejection state were the same as in the verification experiment.

In the comparative experiment, at the start of the experiment, the variation in the ejection port pressure was ±50 Pa, no liquid dripping occurred, and the ink ejection state was also good. At Four days after the start of the experiment, the variation in the ejection pressure became ±400 Pa, and the liquid dripping occurred and the ink ejection state deteriorated (that is, a defective ejection part occurred).

From the result of the verification experiment and the result of the comparative experiment described above, it can be understood that the ejection pressure can be kept stable for a long period of time by adopting the diaphragm type pressure adjusting mechanism as the pressure adjusting mechanism 42. Further, in the comparative experiment, the variation in the ejection pressure became large, the liquid dripping occurred, and the ink ejection state deteriorated. On the other hand, in the verification experiment, the variation in the ejection pressure did not substantially change, liquid dripping did not occur, and the ink ejection state was good. From this, it is understood that liquid dripping and the like were caused by an increase in variation in ink pressure. Further, it has been verified that it is possible to prevent liquid dripping and eject ink in a good ejection state in the manufacture of an organic EL device using a pressure adjusting mechanism that suppresses the pulsation of ink pressure by using a diaphragm as the pressure adjusting mechanism 42.

As described above, the predetermined layer 22 can be formed in a desired state (state at the time of design) by ejecting the ink in a good ejection state without causing liquid dripping. The state of the predetermined layer 22 affects the performance of the organic EL device 10. Therefore, by forming the predetermined layer 22 in a desired state (state at the time of design), it is possible to manufacture an organic EL device 10 having a desired performance (in other words, a good product). As a result, the manufacturing yield of the organic EL device 10 is also improved.

The ink for forming the predetermined layer 22 satisfies at least one of the above Conditions 1 and 2. Such ink is ink that is difficult to maintain the shape of the ink meniscus. When the surface tension is within the range described in Condition 1, the ink is likely to spread, so that liquid dripping is likely to occur, and the ink is likely to spread from the ink ejection port 34 to the peripheral edge thereof and dry/precipitate to clog the ink ejection port 34. When the specific gravity is within the range described in Condition 2, the hunting of the negative pressure for maintaining the shape of the meniscus tends to increase, and the ink tends to dry and precipitate around the ink ejection port 34 to clog the ink ejection port 34. That is, the ink that satisfies at least one of the above Conditions 1 and 2 is also ink that easily causes liquid dripping or easily clogs the ink ejection port 34. Therefore, when the predetermined layer 22 is formed using ink satisfying at least one of the above Conditions 1 and 2, the method for manufacturing an organic EL device using the diaphragm type pressure adjusting mechanism 42 is effective.

When the ink circulation is continued for one week or more, the effect of suppressing pulsation is reduced by reducing the air portion of the buffer tank, and as a result, the shape of the ink meniscus becomes unstable and the clogging of the ink ejection port 34 easily occurs. In particular, the above-mentioned problem is likely to occur when the inkjet printing device 24 is kept on standby for one week or longer. Therefore, when the ink circulation is continued for one week or more, the method for manufacturing the organic EL device of this embodiment in which the pulsation of the ink pressure is suppressed by the diaphragm type pressure adjusting mechanism 42 is effective.

In the method for manufacturing an organic EL device including the case where the inkjet printing device 24 is kept on standby, when the ink is periodically purged from the inkjet head 28, the fluctuation of the ink density due to the evaporation of the ink at the ink ejection port 34 can be suppressed. Therefore, it is easier to maintain the shape of the ink meniscus, and it is possible to prevent clogging of the ink ejection port 34. As a result, the manufacturing yield of the organic EL device 10 is further improved.

The various embodiments of the invention have been described above. However, the invention is not limited to the various embodiments, and is intended to include the scope indicated by the claims and to include all changes within the meaning and scope equivalent to the claims.

For example, the drive unit for flowing ink in a flow path of an inkjet printing device is not limited to a pump as long as ink can flow in the flow path. Further, the inkjet printing device does not have to be a circulation type inkjet printing device.

The form in which the first electrode layer is an anode layer and the second electrode layer is a cathode layer has been described. However, the first electrode layer may be a cathode layer and the second electrode layer may be an anode layer.

The invention is also applicable to the manufacturing of organic electronic devices other than organic EL devices, such as organic solar cells, organic photodetectors, and organic transistors. Further, the invention is also applicable to the manufacturing of an electronic device in which all the functional layers of the device functional portion are made of an inorganic material.

### DESCRIPTION OF REFERENCE SIGNS

- 10...: Organic EL device (electronic device)
- 12...: Substrate
- 14...: Anode layer (first electrode layer)
- 16...: Device functional portion
- 18...: Cathode layer (second electrode layer)
- 24...: Inkjet printing device
- 28...: Inkjet head
- 30...: Ink supply unit
- 38...: Flow path
- 40...: Pump (drive unit)
- 42...: Pressure adjusting mechanism

## Claims

1. A method for manufacturing an electronic device, comprising:
forming a first electrode layer on a substrate;
forming a device functional portion, which includes one or a plurality of functional layers, on the first electrode layer; and
forming a second electrode layer on the device functional portion,
wherein at least one of the first electrode layer, the one or the plurality of functional layers, and the second electrode layer is formed by coating a base substrate containing the substrate with ink containing a material of the at least one layer from an inkjet printing device,
wherein the inkjet printing device includes
an ink supply unit,
an inkjet head that includes an ink ejection port for ejecting the ink toward the base substrate,
a flow path of the ink which connects the ink supply unit and the inkjet head,
a drive unit that is arranged between the ink supply unit and the inkjet head on the flow path to flow the ink to the flow path, and
a diaphragm type pressure adjusting mechanism that is arranged between the drive unit and the inkjet head on the flow path, and
wherein the ink satisfies at least one of a surface tension of 15 mN/m to 25 mN/m and a specific gravity of 1.5 or more.

2. The method for manufacturing the electronic device according to claim 1,
wherein the ink is circulated between the ink supply unit and the inkjet head.

3. The method for manufacturing the electronic device according to claim 2,
wherein the ink is circulated continuously between the ink supply unit and the inkjet head for one week or more.

4. The method for manufacturing the electronic device according to any one of claims 1 to 3,
wherein the ink is periodically purged from the inkjet head.

5. The method for manufacturing the electronic device according to any one of claims 1 to 4,
wherein the ink contains a solvent having a boiling point of 200°C or higher and a substance having a 1% or lower solubility to the solvent.

6. The method for manufacturing the electronic device according to any one of claims 1 to 5,
wherein the at least one layer is a layer included in the device functional portion.

7. The method for manufacturing the electronic device according to any one of claims 1 to 6,
wherein the device functional portion includes an organic light emitting layer.
